# EUROPÄISCHE PATENTANMELDUNG

(11) **EP 1 956 376 A1**
(43) Veröffentlichungstag der Anmeldung: **13.08.2008**
(21) Anmeldenummer: 08001275.0
(22) Anmeldetag: 24.01.2008
(51) Int. Cl.: G01R 1/073

(54) **Elektrische Prüfeinrichtung zur Prüfung von elektrischen Prüflingen**

(30) Priorität: 08.02.2007 DE 102007007741; 17.01.2008 DE 102008004800
(71) Anmelder: Feinmetall GmbH, 71083 Herrenberg (DE)
(72) Erfinder: Steidle, Georg, 71111 Waldenbuch (DE); Stolp, Peter, 72119 Ammerbuch (DE); Böhm, Gunther, 71154 Nufringen (DE)
(74) Vertreter: Grosse, Rainer

(57) **Zusammenfassung**

Die Erfindung betrifft eine elektrische Prüfeinrichtung (1) zur Prüfung von elektrischen Prüflingen (2), vorzugsweise Wafern (3), mit mindestens einer elektrischen Kontaktanordnung (5) und mindestens einer elektrischen, mit mindestens einem elektrischen/elektronischen Bauteil (16) versehenen Anschlussvorrichtung (7), die Kontaktflächen (13) für eine Berührungskontaktierung der mit dem Prüfling (2) kontaktierbaren Kontaktanordnung (5) besitzt und die ein Leitersubstrat (9) und ein Anschlusselement (8) aufweist. Es ist vorgesehen dass sich das elektrische/elektronische Bauteil (16) in/an dem Anschlusselement (8) befindet.

## Beschreibung

Die Erfindung betrifft eine elektrische Prüfeinrichtung zur Prüfung von elektrischen Prüflingen, vorzugsweise Wafern, mit mindestens einer elektrischen Kontaktanordnung und mindestens einer elektrischen, mit mindestens einem elektrischen/elektronischen Bauteil versehenen Anschlussvorrichtung, die Kontaktflächen für eine Berührungskontaktierung der mit dem Prüfling kontaktierbaren Kontaktanordnung besitzt und die ein Leitersubstrat und ein Anschlusselement aufweist.

Elektrische Prüfeinrichtungen der eingangs genannten Art dienen dazu, einen Prüfling elektrisch zu kontaktieren, um seine Funktionsfähigkeit zu testen. Die elektrische Prüfeinrichtung stellt elektrische Verbindungen zum Prüfling her, das heißt, sie kontaktiert einerseits elektrische Anschlüsse des Prüflings und stellt andererseits elektrische Kontakte zur Verfügung, die mit einem Prüfsystem verbunden werden, das mittels der Prüfeinrichtung dem Prüfling elektrische Signale zuführt, um für eine Funktionsprüfung beispielsweise Widerstandsmessungen, Strom- und Spannungsmessungen und so weiter durchzuführen. Da es sich bei dem elektrischen Prüfling oftmals um ein extrem kleines elektronisches Bauelement handelt, beispielsweise um einen Wafer, besitzt die Kontaktanordnung entsprechend dimensionierte Kontaktelemente. Um eine elektrische Anschlussmöglichkeit zum erwähnten Prüfsystem zu schaffen, stehen die Kontaktelemente der Kontaktanordnung in Berührungskontakt mit einer Anschlussvorrichtung, die unter anderem eine Umsetzung auf einen größeren Kontaktabstand vornimmt und insofern das Anschließen von elektrischen Verbindungskabeln ermöglicht, die zum Prüfsystem führen. Bei der so genannten "verdrahteten Prüfkarte" führen von den Kontaktflächen Drähte zu Kontakten des Leitersubstrats und/oder zu elektrischen/elektronischen Bauteilen, die sich auf dem Leitersubstrat befinden. Diese elektrischen/elektronischen Bauteile stellen die Funktionsfähigkeit der Prüfkarte sicher, das heißt, sie vermitteln entsprechende elektrische Eigenschaften. Die elektrischen/elektronischen Bauteile werden auf das Leitersubstrat, das insbesondere als Leiterplatte ausgebildet ist, aufgelötet.

Bei den bekannten elektrischen Prüfeinrichtungen kann es bei bestimmten Prüfbedingungen zu Einschränkungen kommen, beispielsweise dann, wenn die Prüfung mit sehr hohen elektrischen Frequenzen erfolgt.

Der Erfindung liegt daher die Aufgabe zugrunde, eine elektrische Prüfeinrichtung der eingangs genannten Art vorzuschlagen, die eine zuverlässige Prüfung des Prüflings auch unter extremen Prüfbedingungen ermöglicht.

Diese Aufgabe wird erfindungsgemäß dadurch gelöst, dass sich das elektrische/elektronische Bauteil in/an dem Anschlusselement befindet. Aufgrund der erfindungsgemäßen Ausgestaltung wird die Leitungslänge zwischen dem Prüfling und dem elektrischen/elektronischen Bauteil deutlich verkürzt, da sich das Bauteil in/an dem Anschlusselement befindet. Das Anschlusselement ist sehr nahe zum Prüfling platziert; zwischen dem Prüfling und dem Anschlusselement befindet sich lediglich die Kontaktanordnung. Durch die sehr kurze Leitungslänge zwischen dem elektrischen/elektronischen Bauteil und dem Prüfling ist die Wirksamkeit und Funktionsfähigkeit des elektrischen Bauteils erheblich erhöht.

Der Prüfling kann daher insbesondere auch bei sehr hohen elektrischen Frequenzen getestet werden. Die Positionierung des elektrischen Bauteils in/an dem Anschlusselement ist nicht nur sehr nahe am Prüfling, sondern zudem vorzugsweise in einem Gebiet vorgesehen, das grundsätzlich der Anordnung von Kontakten der Kontaktanordnung vorbehalten ist, sodass durch diese Maßnahme eine Besonderheit vorliegt. Beim Gegenstand der Erfindung liegt insbesondere eine so genannte "verdrahtete Prüfkarte" vor.

Bevorzugt ist vorgesehen, dass das Anschlusselement als Anschlussgehäuse oder Anschlussplatte ausgebildet ist und dass sich das elektrische/elektronische Bauelement im/am Anschlussgehäuse oder in/an der Anschlussplatte befindet.

Nach einer Weiterbildung der Erfindung ist vorgesehen, dass das Anschlusselement, das insbesondere als Anschlussgehäuse oder Anschlussplatte ausgebildet ist, mindestens eine Aufnahme zur Aufnahme des Bauteils aufweist. Bevorzugt kann das elektrische/elektronische Bauteil als SMT-Bauteil, also in (Surface Mount Technology-Bauform) ausgeführt sein.

Nach einer Weiterbildung der Erfindung ist vorgesehen, dass das Anschlusselement, das insbesondere als Anschlussgehäuse oder Anschlussplatte ausgebildet ist, die Kontaktflächen aufweist. Mithin kann das mindestens eine elektrische/elektronische Bauteil in unmittelbarer Nachbarschaft der Kontaktflächen angeordnet werden, wobei die Kontaktflächen über die Kontaktanordnung mit dem Prüfling in Berührungskontakt bringbar sind.

Das Leitersubstrat ist insbesondere als Leiterplatte ausgebildet.

Eine Weiterbildung der Erfindung sieht vor, dass das Leitersubstrat eine Öffnung aufweist, in der sich zumindest bereichsweise das Anschlusselement, das bevorzugt als Anschlussgehäuse oder Anschlussplatte ausgebildet ist, befindet. Die Öffnung dient dazu, das Anschlusselement aufzunehmen, das heißt, das Anschlusselement wird von dem Leitersubstrat, insbesondere der Leiterplatte, umgeben. Bevorzugt befindet sich das Anschlusselement in zentraler Anordnung zum Leitersubstrat, das heißt, die Öffnung ist zentral oder im Wesentlichen zentral im Leitersubstrat ausgebildet.

Nach einer Weiterbildung der Erfindung ist vorgesehen, dass die Aufnahme als Aufnahmevertiefung oder als Aufnahmedurchbruch ausgebildet ist. Durch die Aufnahmevertiefung oder den Aufnahmedurchbruch ist das Bauteil geschützt aufgenommen, wobei dennoch eine Zugänglichkeit von außen besteht, um es beispielsweise im Defektfall austauschen zu können.

Die Kontaktanordnung ist bevorzugt als Kontaktkopf ausgebildet. Die Kontaktanordnung weist bevorzugt als Kontakte Kontaktstifte, insbesondere Knicknadeln, auf, die mit ihren einen Enden die Kontaktflächen und mit ihren anderen Enden den Prüfling kontaktieren können. Bei diesen Kontaktierungen handelt es sich bevorzugt um Berührungskontaktierungen.

Die Anordnung kann so getroffen sein, dass mindestens eine Kontaktfläche mit dem Bauteil elektrisch verbunden ist. Ferner ist bevorzugt vorgesehen, dass mindestens ein Leiter des Leitersubstrats mit dem Bauteil elektrisch verbunden ist. Je nach Ausgestaltung kann das Bauteil direkt oder über eine Verbindungsleitung mit der mindestens einen Kontaktfläche elektrisch verbunden sein. Ferner kann der Leiter des Leitersubstrats direkt oder über eine Verbindungsleitung mit dem Bauelement verbunden sein.

Eine Weiterbildung der Erfindung sieht vor, dass die Aufnahme oder mindestens eine der Aufnahmen an einer der Kontaktanordnung zugewandten und/oder der Kontaktanordnung abgewandten Seite des Anschlusselements, insbesondere des Anschlussgehäuses oder der Anschlussplatte, ausgebildet ist. Die Aufnahme für das Bauelement kann somit auf der dem Prüfling zugewandten Seite des Anschlusselements oder der dem Prüfling abgewandten Seite des Anschlusselements vorgesehen sein. Die Anordnung ist dabei derart getroffen, dass in jedem Falle eine Zugänglichkeit zum Bauelement besteht, um dies bei Bedarf auswechseln zu können.

Nach einer Weiterbildung der Erfindung ist vorgesehen, dass die Aufnahme in einem kontaktflächenfreien Bereich benachbart zu mindestens einer Kontaktfläche angeordnet ist. Obwohl das Gebiet, in dem sich das Bauelement befindet, grundsätzlich für Kontakte der Kontaktanordnung vorbehalten ist, geht die Erfindung diesen Weg und ordnet dort das Bauelement an, wobei es vorzugsweise derart zwischen den Kontakten der Kontaktanordnung platziert wird, dass es nicht störend in Erscheinung tritt.

Bevorzugt ist vorgesehen, dass dem Anschlusselement eine Abstützeinrichtung zugeordnet ist. Da sich bei der Berührungskontaktierung des prüfenden Prüflings die Kontakte der Kontaktanordnung jeweils mit einem Ende am Prüfling und mit dem anderen Ende an der zu kontaktierenden Kontaktfläche des Anschlusselements abstützen, tritt bei jedem Kontakt eine Kontaktkraft auf, die sich in der Summe der Vielzahl der Kontakte zu einer insgesamt hohen Kontaktkraft aufsummiert. Um diese hohe Kontaktkraft ohne unzulässige Verformung von Baugruppen der Prüfeinrichtung aufnehmen zu können, ist die Abstützeinrichtung vorgesehen. Hierbei handelt es sich um ein relativ steifes Bauelement (Stiffener), an der sich das Anschlusselement abstützt.

Bevorzugt ist vorgesehen, dass die Abstützeinrichtung mindestens eine Zugriffsöffnung zum Zugriff zu dem mindestens einen Bauteil aufweist. Demzufolge ist die Abstützeinrichtung derart gestaltet, dass durch die Zugriffsöffnung ein Zugang zu dem Bauteil besteht, sodass dieses zum Beispiel bei Bedarf ausgetauscht werden kann.

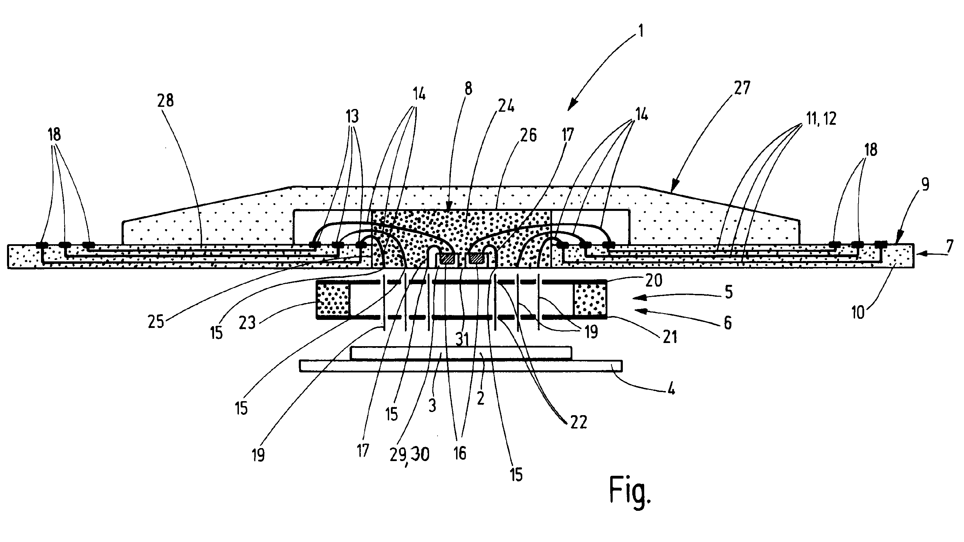

Die Zeichnung veranschaulicht die Erfindung anhand eines Ausführungsbeispiels, und zwar zeigt die Figur eine schematische Längsschnittansicht durch eine elektrische Prüfeinrichtung.

Die Figur zeigt in schematischer Darstellung einen Längsschnitt durch eine elektrische Prüfeinrichtung 1, die zur elektrischen Berührungskontaktierung eines elektrischen Prüflings 2 dient. Die Prüfeinrichtung 1 ist mittels nicht dargestellter elektrischer Kabelverbindungen an ein ebenfalls nicht dargestelltes Prüfsystem angeschlossen, um den Prüfling 2 einer elektrischen Prüfung zu unterziehen. Der Prüfling 2, der insbesondere als Wafer 3 ausgebildet sein kann, befindet sich auf einem abstützenden Träger 4. Der Prüfling 2 weist nicht näher dargestellte Anschlussstellen auf, die mittels der elektrischen Prüfeinrichtung 1 für die Prüfung berührungskontaktiert werden. Hierzu werden der Prüfling 2 und die elektrische Prüfeinrichtung 1 relativ aufeinander zu bewegt.

Die Prüfeinrichtung 1 weist eine Kontaktanordnung 5 auf, die als Kontaktkopf 6 ausgebildet ist. Ferner besitzt die Prüfeinrichtung 1 eine Anschlussvorrichtung 7, die ein Anschlusselement 8 und ein Leitersubstrat 9 aufweist. Das Leitersubstrat 9 ist als Leiterplatte 10, insbesondere als mehrlagige Leiterplatte 10 ausgebildet. Sie besitzt Leiter 11, die bevorzugt als Leiterbahnen 12 ausgebildet sind und die an ihren dem Kontaktkopf 6 abgewandten Enden Kontaktflächen 13 aufweisen, die über elektrische Verbindungsleitungen 14 zu Kontaktflächen 15 oder zu elektrischen/elektronischen Bauteilen 16 führen. Die Kontaktflächen 15 werden insbesondere von den Stirnenden der vorzugsweise als Drahtverbindungen ausgebildeten Verbindungsleitern 14 gebildet. Ferner sind Verbindungsleiter 17 vorgesehen, die von den Bauteilen 16 zu Kontaktflächen 15 führen. Die Leiter 11 besitzen an ihren anderen, radial außen liegenden Enden elektrische Anschlussflächen 18, die über die erwähnten, nicht dargestellten Kabelverbindungen mit dem nicht dargestellten Prüfsystem verbindbar sind. Die Anordnung ist so getroffen, dass die Anschlussvorrichtung eine Umsetzvorrichtung bildet, das heißt, der sehr enge Abstand der sehr kleinen Kontaktflächen 15 (Durchmesser zum Beispiel 50 bis 300 µm) wird über die Verbindungsleiter 14 und die Leiter 11 in größere Abstände der Anschlussflächen 18 umgesetzt. Die Anschlussflächen 18 haben jeweils eine Größe, die es ermöglicht, auf einfache Art Kontakt mit den nicht dargestellten Kabelverbindungen herstellen zu können. Der Kontaktkopf 6 ist mit einer Vielzahl von längsverschieblich gelagerten, länglichen Kontakten 19 versehen, die vorzugsweise als Kontaktnadeln, insbesondere Knicknadeln, ausgebildet sein können, die mit ihren einen Endbereichen dem Prüfling 2 und mit ihren anderen Endbereichen der Anschlussvorrichtung 7 zugeordnet sind.

Bei der Prüfung des Prüflings 2 bewegt sich die Prüfeinrichtung 1 in Richtung auf den Prüfling 2 und/oder der Prüflings 2 bewegt sich in Richtung auf die Prüfeinrichtung 1, sodass die Stirnenden der Kontakte 19 einerseits auf den Prüfling 2 und andererseits auf die Kontaktflächen 15 auftreffen. Da die Kontakte 19 insbesondere als Knickdrähte ausgebildet sind, das heißt, sie sind in axialer Richtung durch Durchbiegung leicht federnd gestaltet, ist eine einwandfreie Kontaktierung möglich. Der Kontaktkopf 6 besitzt zwei mit Abstand zueinander liegende, parallele Keramikplatten 20, 21, die mit Lagerbohrungen 22 zur Aufnahme der Kontakte 19 versehen sind. Die parallele Abstandslage der beiden Keramikplatten 20 und 21 ist mittels eines Abstandshalters 23 realisiert.

Die Verbindungsleiter 14 verlaufen zumindest abschnittsweise durch das Anschlusselement 8 und sind dort fixiert. Das Anschlusselement 8 kann gemäß dem dargestellten Ausführungsbeispiel als Anschlussgehäuse 24 ausgebildet sein. Es ist beispielsweise als Gießblock realisiert, in dem die Verbindungsleiter 14 in fester Position eingegossen sind. Das Leitersubstrat 9 weist eine Öffnung 25 auf, in der sich bereichsweise das Anschlusselement 8 befindet. Das Anschlusselement 8 weist eine Oberseite 26 auf, die sich an einer Abstützeinrichtung 27 abstützt. Die Abstützeinrichtung 27 ist als steifes Bauelement ausgebildet, sodass die von den Kontakten 19 stammenden Kontaktkräfte ohne Verformungen an Bauelementen der elektrischen Prüfeinrichtung 1 aufgenommen werden können. Das Leitersubstrat 9 weist eine Oberseite 28 auf, die sich ebenfalls an der Abstützeinrichtung 27 abstützt.

Nach einem weiteren, nicht dargestellten Ausführungsbeispiel kann das Abstützelement 8 auch flacher ausgebildet sind, sodass es kein Anschlussgehäuse 24, sondern eine Anschlussplatte bildet.

Das Anschlusselement 8 weist - unabhängig davon, ob es als Anschlussgehäuse 24 oder Anschlussplatte ausgebildet ist - die Kontaktflächen 15 auf, die mit den Verbindungsleitern 14 beziehungsweise 17 verbunden sind oder von den Stirnflächen dieser Verbindungsleiter 14, 17 gebildet werden. Ferner ist dem Anschlusselement 8 mindestens ein elektrisches/elektronisches Bauteil 16, beispielsweise ein Kondensator, direkt zugeordnet, das heißt, das Bauteil 16 befindet sich in oder an dem Anschlusselement 8. Es kann dort - wie beim Ausführungsbeispiel der Figur dargestellt - in einer Aufnahme 29 angeordnet sein. Bei der Aufnahme 29 handelt es sich um eine Aufnahmevertiefung 30, die an einer Unterseite 31 des Anschlusselements 8 ausgebildet ist. Im dargestellten Ausführungsbeispiel sind beispielsweise zwei Aufnahmen 29 vorgesehen, die als Aufnahmevertiefungen 30 ausgebildet sind, und jeweils ein Bauteil 16 aufnehmen. Aufgrund der Anordnung der Bauteile 16 in dem Anschlusselement fallen die Verbindungsleiter 17 sehr kurz aus, das heißt, die Bauteile 16 sind sehr nahe dem Prüfling 2 positioniert, sodass die elektrischen Verbindungswege zwischen Bauteil 16 und Prüfling 2 so kurz sind, dass insbesondere auch Messungen mit sehr hohen Frequenzen möglich sind. Die elektrische Funktionsfähigkeit der Bauteile 16 ist somit stets sichergestellt. Ferner lassen sich auch extreme Prüfbedingungen realisieren, die bei über längere Leitungsverbindungen angeschlossenen elektrischen/elektronischen Bauteilen gar nicht realisierbar wären.

Aufgrund der Anordnung des elektrischen/elektronischen Bauteils 16 im Bereich einer der Außenseiten des Anschlusselements 8, insbesondere an der Unterseite 31 oder der Oberseite 26, in einer Aufnahmevertiefung 30 oder nicht in vertiefter Position, ist stets eine von außen mögliche Zugänglichkeit zum Bauteil 16 gegeben, sodass dieses bei Bedarf ausgetauscht werden kann. Das elektrische/elektronische Bauteil 16 kann als SMT-Bauteil ausgebildet sein (Surface Mount Technology-Ausführung). Alternativ ist auch eine Ausführung des Bauteils 16 denkbar, bei der es eigene Anschlussdrähte besitzt, die bei hinreichender Länge gegebenenfalls direkt mit den Kontaktflächen 13 verbunden werden können beziehungsweise die Kontaktflächen 15 bilden.

Sofern sich das elektrische/elektronische Bauteil 16 auf der Oberseite 26 des Anschlusselements 8 befindet oder im Bereich der Oberseite 26, zum Beispiel in einer Aufnahmevertiefung 30, angeordnet ist, ist die Abstützvorrichtung 27 bevorzugt mit einer Zugriffsöffnung versehen, die einen Zugriff von außen auf das Bauteil 16 ermöglicht. Diese Ausführungsform ist in der Figur nicht dargestellt.

Wenn im Vorstehenden von einem oder mehreren elektrischen/elektronischen Bauteilen 16 gesprochen wird, so ist dieses keine Beschränkung auf die Anzahl der Bauelemente, da die Erfindung nicht von einem oder mehreren vorhandenen Bauelementen 16 abhängig ist, sondern sich insbesondere auf die spezielle Positionierung des Bauteils 16 oder der Bauteile 16 bezieht.

## Patentansprüche

1. Elektrische Prüfeinrichtung zur Prüfung von elektrischen Prüflingen, vorzugsweise Wafern, mit mindestens einer elektrischen Kontaktanordnung und mindestens einer elektrischen, mit mindestens einem elektrischen/elektronischen Bauteil versehenen Anschlussvorrichtung, die Kontaktflächen für eine Berührungskontaktierung der mit dem Prüfling kontaktierbaren Kontaktanordnung besitzt und die ein Leitersubstrat und ein Anschlusselement aufweist, **dadurch gekennzeichnet, dass** sich das elektrische/elektronische Bauteil (16) in/an dem Anschlusselement (8) befindet.

2. Prüfeinrichtung nach Anspruch 1, **dadurch gekennzeichnet, dass** das Anschlusselement (8) als Anschlussgehäuse (24) oder Anschlussplatte ausgebildet ist und dass sich das elektrische/elektronische Bauteil (16) im/am Anschlussgehäuse (24) oder in/an der Anschlussplatte befindet.

3. Prüfeinrichtung nach einem der vorhergehenden Ansprüche, **dadurch gekennzeichnet, dass** das Anschlusselement (8) mindestens eine Aufnahme (29) zur Aufnahme des Bauteils (16) aufweist.

4. Prüfeinrichtung nach einem der vorhergehenden Ansprüche, **dadurch gekennzeichnet, dass** das Anschlusselement (8) die Kontaktflächen (15) aufweist.

5. Prüfeinrichtung nach einem der vorhergehenden Ansprüche, **dadurch gekennzeichnet, dass** das Leitersubstrat (9) als Leiterplatte (10) ausgebildet ist.

6. Prüfeinrichtung nach einem der vorhergehenden Ansprüche, **dadurch gekennzeichnet, dass** das Leitersubstrat (9) eine Öffnung (25) aufweist, in der sich zumindest bereichsweise das Anschlusselement (8) befindet.

7. Prüfeinrichtung nach einem der vorhergehenden Ansprüche, **dadurch gekennzeichnet, dass** die Aufnahme (29) als Aufnahmevertiefung (30) oder als Aufnahmedurchbruch ausgebildet ist.

8. Prüfeinrichtung nach einem der vorhergehenden Ansprüche, **dadurch gekennzeichnet, dass** die Kontaktanordnung (5) ein Kontaktkopf (6) ist.

9. Prüfeinrichtung nach einem der vorhergehenden Ansprüche, **dadurch gekennzeichnet, dass** die Kontaktanordnung (5) als Kontakte (19) Kontaktstifte, insbesondere Knicknadeln, aufweist, die mit ihren einen Enden die Kontaktflächen (15) und mit ihren anderen Enden den Prüfling (2) berührungskontaktieren können.

10. Prüfeinrichtung nach einem der vorhergehenden Ansprüche, **dadurch gekennzeichnet, dass** mindestens eine Kontaktfläche (15) mit dem Bauteil (16) elektrisch verbunden ist.

11. Prüfeinrichtung nach einem der vorhergehenden Ansprüche, **dadurch gekennzeichnet, dass** mindestens ein Leiter (11) des Leitersubstrats (9) mit dem Bauteil (16) elektrisch verbunden ist.

12. Prüfeinrichtung nach einem der vorhergehenden Ansprüche, **dadurch gekennzeichnet, dass** das Bauteil (16) an mindestens eine elektrische Verbindungsleitung (14,17), insbesondere einen elektrischen Draht, angeschlossen ist.

13. Prüfeinrichtung nach einem der vorhergehenden Ansprüche, **dadurch gekennzeichnet, dass** die Aufnahme (29) oder mindestens eine der Aufnahmen (29) an einer der Kontaktanordnung (5) zugewandten und/oder der Kontaktanordnung (5) abgewandten Seite des Anschlusselements (8) ausgebildet ist.

14. Prüfeinrichtung nach einem der vorhergehenden Ansprüche, **dadurch gekennzeichnet, dass** die Aufnahme (29) in einem kontaktflächenfreien Bereich benachbart zu mindestens einer Kontaktfläche (15) angeordnet ist.

15. Prüfeinrichtung nach einem der vorhergehenden Ansprüche, **dadurch gekennzeichnet, dass** dem Anschlusselement (8) eine Abstützeinrichtung (27) zugeordnet ist.

16. Prüfeinrichtung nach einem der vorhergehenden Ansprüche, **dadurch gekennzeichnet, dass** die Abstützeinrichtung (27) auf einer der Kontaktanordnung (5) abgewandten Seite des Anschlusselements (8) angeordnet ist.

17. Prüfeinrichtung nach einem der vorhergehenden Ansprüche, **dadurch gekennzeichnet, dass** die Abstützeinrichtung (27) mindestens eine Zugriffsöffnung zum Zugriff zu dem Bauteil (16) aufweist.
